(19) Europäisches Patentamt
European Patent Office
Office européen des brevets

(11) Numéro de publication: 0 208 258
A1

(12) # DEMANDE DE BREVET EUROPEEN

(21) Numéro de dépôt: 86109048.8

(22) Date de dépôt: 03.07.86

(51) Int. Cl.⁴: C 08 G 85/00
C 08 G 79/00

(30) Priorité: 05.07.85 FR 8510325

(43) Date de publication de la demande:
14.01.87 Bulletin 87/3

(84) Etats contractants désignés:
AT BE CH DE FR GB IT LI LU NL SE

(71) Demandeur: COMPAGNIE GENERALE D'ELECTRICITE
Société anonyme dite:
54, rue La Boétie
F-75382 Paris Cedex 08(FR)

(72) Inventeur: Cassoux, Patrick
14 rue du Romarin
F-31520 Ramonville Saint Agne(FR)

(72) Inventeur: Kahn, Olivier
6 rue Baudin
F-94200 Ivry sur Seine(FR)

(72) Inventeur: Le Méhauté, Alain
3 route de Belleville
F-91190 Gif sur Yvette(FR)

(72) Inventeur: Sautet, Philippe
5 rue La Fontaine
F-78190 Trappes(FR)

(74) Mandataire: Weinmiller, Jürgen et al.
Lennéstrasse 9
D-8133 Feldafing(DE)

(54) **Procédé de fabrication de structures macromoléculaires et composes obtenus.**

(57) Nouvelles structures macromoléculaires présentant une organisation fractale et susceptibles d'applications dans les domaines de l'électrochimie, la cryoélectricité, le magnétisme, l'électrotechnique et l'électronique moléculaire.

EP 0 208 258 A1

./...

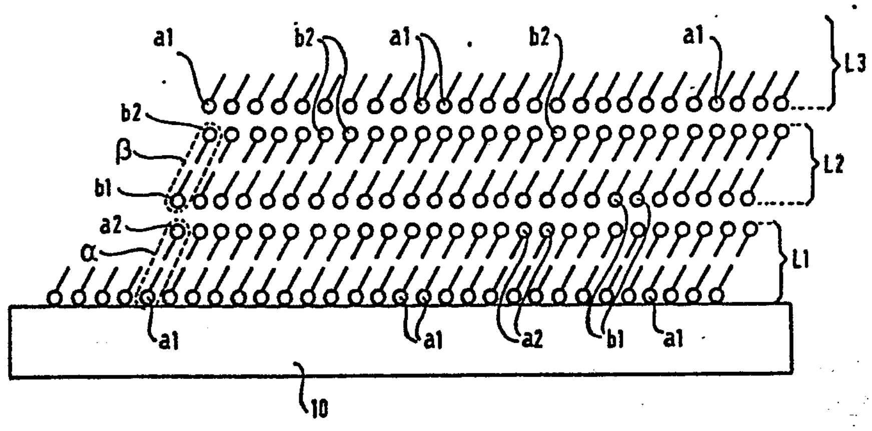
a1
b2
a1
b2
a1
L3
b2
β
b1
L2
a2
α
L1
a1
a1
a2
b1
a1
10

Procédé de fabrication de structures macromoléculaires et composés obtenus

La présente invention concerne des structures macromoléculaires trouvant des applications notamment dans les domaines de l'électrochimie, la cryoélectricité, le magnétisme, l'électrotechnique, l'électronique moléculaire ; elle concerne en particulier des procédés de fabrication de telles structures.

La présente invention a pour but de réaliser de nouveaux matériaux présentant des propriétés géométriques particulièrement intéressantes dans les domaines précités.

La présente invention a pour objet un procédé de fabrication de structures macromoléculaires tel que les composés obtenus présentent une organisation fractacle définie comme l'existence d'une séquence d'ions, d'atomes, ou de molécules présentant des propriétés de self-similarité.

Une telle macromolécule peut être définie par exemple de la manière suivante.

On part d'une première entité ou molécule $\alpha$ et d'une seconde entité ou molécule $\beta$ ; on définit une séquence f qui permet de réaliser une molécule $A_1 = f(\alpha, \beta)$ et une molécule $B_1 = f(\beta, \beta)$, puis une molécule $A_2 = f(A_1, B_1)$ et une molécule $B_2 = f(B_1, B_1)$, et ainsi de suite jusqu'à n, avec $A_n = f(A_{n-1}, B_{n-1})$ et $B_n = f(B_{n-1}, B_{n-1})$.

Selon une variante, on réalise une molécule $A_1 = f(\alpha, \beta)$ et une molécule $B_1 = f(\alpha, \alpha)$, puis une molécule $A_2 = f(A_1, B_1)$ et une molécule $B_2 = f(A_1, A_1)$, et ainsi de suite jusqu'à n, avec $A_n = f(A_{n-1}, B_{n-1})$ et $B_n = f(A_{n-1}, A_{n-1})$.

Les macromolécules qui résultent de la synthèse selon f ont une structure à homothétie interne, c'est-à-dire une structure qui, à certains égards (séquence des atomes, séquence de macromères, état de spins, polarisabilité, état d'oxydoréduction...), présente une invariance d'échelle quant à l'organisation interne. Il en résulte des effets coopératifs, induits par les propriétés d'homothétie de la métrique au niveau moléculaire sur les propriétés physico-chimiques macroscopiques du matériau telles qu'elles peuvent être décrites dans les articles suivants :

- A. Le Méhauté et G. Crépy - Solid Strate Ionics 9/10 (1983) p. 17.
- A. Le Méhauté - Journal of Statistical Physics - 36 - 5/6 (1984)- p. 665
- A. Le Méhauté - Séminaire Hausdorff sur la notion de dimension non entière (Masson).

Ces macromolécules, lorsqu'elles sont topologiquement unidimensionnelles, présentent une dimension fractale inférieure à 1.

La séquence f peut être alors telle que :

$A_n = A_{n-1}\ B_{n-1}\ A_{n-1}$ et $B_n = B_{n-1}\ B_{n-1}\ B_{n-1}$, la dimension fractale des molécules étant donnée par log2/log3.

La séquence f peut être telle que :

$A_n = A_{n-1}\ B_{n-1}\ A_{n-1}\ B_{n-1}\ A_{n-1}$ et $B_n = B_{n-1}B_{n-1}B_{n-1}B_{n-1}B_{n-1}$,
la dimension fractale des molécules étant donnée par log3/log5.

La séquence f peut être telle que :

$A_n = A_{n-1}\ B_{n-1}\ A_{n-1}\ B_{n-1}$, $B_n = B_{n-1}\ B_{n-1}\ B_{n-1}\ B_{n-1}$
ou $A_n = A_{n-1}\ A_{n-1}\ B_{n-1}\ B_{n-1}$, $B_n = B_{n-1}\ B_{n-1}\ B_{n-1}\ B_{n-1}$,
la dimension fractale des molécules étant donnée par log2/log4.

Selon une autre possibilité la séquence f peut être telle que :

$A_n = A_{n-1}\ B_{n-1}\ A_{n-1}$ et $B_n = A_{n-1}\ A_{n-1}\ A_{n-1}$,
Elle peut être telle que :

$A_n = A_{n-1}\ B_{n-1}\ A_{n-1}\ B_{n-1}\ A_{n-1}$ et $B_n = A_{n-1}\ A_{n-1}\ A_{n-1}\ A_{n-1}\ A_{n-1}$,
Elle peut aussi être telle que :

$A_n = A_{n-1}\ B_{n-1}\ A_{n-1}\ B_{n-1}$ et $B_n = A_{n-1}\ A_{n-1}\ A_{n-1}\ A_{n-1}$,
Elle peut être aussi telle que :

$A_n = A_{n-1}\ A_{n-1}\ B_{n-1}\ B_{n-1}$ et $B_n = A_{n-1}\ A_{n-1}\ A_{n-1}\ A_{n-1}$.

De manière générale les structures macromoléculaires selon l'invention sont montées à la manière dont CANTOR fait ses découpages géométriques ou diadiques (cf B. MANDELBROT "the geometry of the nature" Freemann - 1982).

Selon un premier procédé, on effectue une synthèse par voie chimique utilisant une procédure chimique de blocage-déblocage asymétrique des molécules pour l'élaboration de la séquence f. Les molécules de départ sont choisies de préférence parmi les composés azotés et les composés soufrés ou séléniés. Les bloqueurs asymétriques sont des

composés aminés choisis de préférence mais pas exclusivement parmi des éthylènes diamines et des éthylènes triamines.

Selon un second procédé, on met en oeuvre une synthèse asymétrique faisant intervenir une adsorption sélective sur des surfaces qui sont ensuite mises en contact pour assurer les réactivités asymétriques ; lesdites surfaces sont couvertes par exemple de polymères conducteurs choisis parmi les polyacétylènes, les polypyrroles, les polythiophènes, et leurs dérivés. Le contrôle des processus d'adsorption-désadsorption est par exemple assuré par voie électrochimique. La réactivité est assurée par des techniques de type chromatographique, les surfaces étant mises en contact par pression et baignées dans des solutions d'échange.

Dans ce second procédé, les molécules de départ sont choisies de préférence parmi les composés de coordination soufrés et séléniés et parmi les composés de coordination azotés.

La présente invention a également pour objet des composés obtenus par le procédé précédent.

De tels composés peuvent se présenter sous forme de couches moléculaires superposées dites couches de Langmuir Blodgett.

La théorie des couches de LangmuirBlodgett est décrite par exemple dans le "Journal of Molecular Electronics" vol.1 pages 3 à 17 juillet 1985".

Selon l'invention, les couches sont superposées selon ladite séquence.

La présente invention a également pour objet des utilisations des structures macromoléculaires précédemment définies notamment comme pigments magnétiques ou comme supraconducteurs macromoléculaires.

D'autres caractéristiques et avantages de la présente invention apparaîtront au cours de la description des exemples suivants donnés à titre non limitatif. La figure unique illustre un exemple de couches de Langmuir.

Dans un premier mode de réalisation, on part d'une molécule $\alpha$ et d'une molécule $\beta$ pouvant présenter deux liaisons disponibles et on choisit un mode de synthèse de manière à former par exemple :

- une molécule $A_1 = \alpha\beta\alpha$
- une molécule $B_1 = \beta\beta\beta$

et on recommence la même démarche pour obtenir avec $A_1$ et $B_1$

- une molécule $A_2 = A_1\ B_1\ A_1 = \alpha\beta\alpha\ \beta\beta\beta\ \alpha\beta\alpha$
- une molécule $B_2 = B_1\ B_1\ B_1 = \beta\beta\beta\ \beta\beta\beta\ \beta\beta\beta$

et ainsi de suite avec $A_{n-1}$, $B_{n-1}$ pour $A_n$, $B_n$ ....

Dans l'exemple cité, la molécule a une dimension cantorienne égale à log2/log3.

Dans un second exemple, la séquence choisie est d'une autre nature ; elle est telle que :

$A_1 = \alpha\beta\alpha\beta\alpha$

$B_1 = \beta\beta\beta\beta\beta$

$A_2 = A_1B_1A_1B_1A_1 = \alpha\beta\alpha\beta\alpha\ \beta\beta\beta\beta\beta\ \alpha\beta\alpha\beta\alpha\ \beta\beta\beta\beta\beta\ \alpha\beta\alpha\beta\alpha$

$B_2 = B_1B_1B_1B_1B_1 = \beta\beta\beta\beta\beta\ \beta\beta\beta\beta\beta\ \beta\beta\beta\beta\beta\ \beta\beta\beta\beta\beta\ \beta\beta\beta\beta\beta$

etc.

Une telle molécule a alors une dimension cantorienne égale à log3/log5.

Selon une variante on part d'une molécule $\alpha$ et d'une molécule $\beta$ pouvant présenter deux liaisons disponibles et on choisit un mode de synthèse de manière à former par exemple :

- une molécule $A_1 = \alpha\beta\alpha$
- une molécule $B_1 = \alpha\alpha\alpha$

et on recommence la même démarche avec $A_1$ et $B_1$ :

- une molécule $A_2 = A_1\ B_1\ A_1 = \alpha\beta\alpha\ \alpha\alpha\alpha\ \alpha\beta\alpha$ ,
- une molécule $B_2 = A_1\ A_1\ A_1 = \alpha\beta\alpha\ \alpha\beta\alpha\ \alpha\beta\alpha$ ,

et ainsi de suite avec $A_{n-1}$ , $B_{n-1}$ , pour $A_n$ et $B_n$ .

Dans un second exemple, la séquence choisie est d'une autre nature ; elle est telle que

$A_1 = \alpha\beta\alpha\beta\alpha$

$B_1 = \alpha\alpha\alpha\alpha\alpha$

$A_2 = A_1\ B_1\ A_1\ B_1\ A_1 = \alpha\beta\alpha\beta\alpha\alpha\alpha\alpha\alpha\alpha\alpha\beta\alpha\beta\alpha\alpha\alpha\alpha\alpha\alpha\alpha\beta\alpha\beta\alpha$

$B_2 = A_1\ A_1\ A_1\ A_1\ A_1 = \alpha\beta\alpha\beta\alpha\alpha\beta\alpha\beta\alpha\alpha\beta\alpha\beta\alpha\alpha\beta\alpha\beta\alpha\alpha\beta\alpha\beta\alpha$

etc.

Comme on le voit à la lumière de ces exemples, les molécules formées présentent des propriétés de similarité interne au sens cantorien du terme, et c'est la séquence f qui définit la loi de similarité.

Pour que les molécules initiales puissent se lier l'une à l'autre, il faut qu'elles puissent réagir tant à droite qu'à gauche de la séquence.

Schématiquement, on note le bloquage des liaisons par des crochets et les liaisons libres par des flèches. Ainsi à titre d'exemple la synthèse des molécules $A_1$ et $B_1$ peut être schématisée de la manière suivante :

$$[\alpha \rightarrow \; + \leftarrow \beta \rightarrow \; + \leftarrow \alpha] \rightarrow [\alpha\beta\alpha] = A_1$$

$$[\beta \rightarrow \; + \leftarrow \beta \rightarrow \; + \leftarrow \beta] \rightarrow [\beta\beta\beta] = B_1$$

puis

$$[\alpha\beta\alpha \rightarrow + \leftarrow \beta\beta\beta \rightarrow + \leftarrow \alpha\beta\alpha] \longrightarrow [\alpha\beta\alpha\beta\beta\beta\alpha\beta\alpha] = A_2$$

On peut dire que, par cette première méthode, c'est la séquence qui réagit.

Selon une seconde méthode, la synthèse de la molécule $A_2$ prédéterminée peut être réalisée unité par unité ; autrement dit on réalise successivement :

$[\alpha\beta \rightarrow$ , $[\alpha\beta\alpha \rightarrow$ , $[\alpha\beta\alpha\beta$ , $[\alpha\beta\alpha\beta\beta \rightarrow$ , etc.....

Que ce soit dans la première ou dans la seconde méthode, la synthèse exige d'assurer à volonté le blocage ou le déblocage des liaisons de façon totalement asymétrique, afin d'obtenir par exemple :

$$[\alpha\beta\alpha] \longrightarrow [\alpha\beta\alpha \rightarrow$$

ou :

$$[\beta\beta\beta] \longrightarrow [\beta\beta\beta \rightarrow$$

Par ailleurs les molécules α, β, doivent avoir des structures particulières pour pouvoir subir les réactions prévues.

Dans une première série d'exemples, on peut mettre en oeuvre des composés complexants azotés de type ci-après.

α peut présenter les formes suivantes :

$\alpha_1$ :

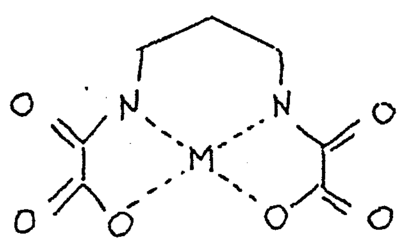

$\alpha_3$ :

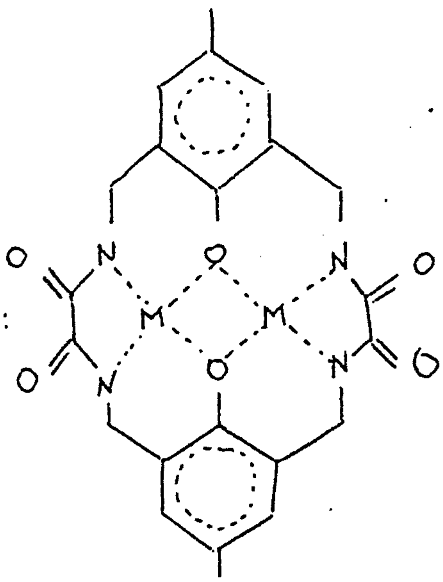

où M est un métal

$\alpha_2$ :

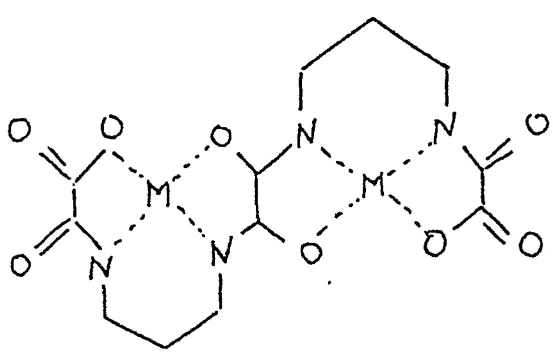

$\beta_1$, $\beta_2$, $\beta_3$ sont analogues, mais M est remplacé par M', M et M' étant par exemple, le manganèse, le cuivre, cobalt, le fer, ou de façon générale tout métal de transition.

On va développer ci-dessous deux voies de synthèse, une voie chimique et une voie physico-chimique pour réaliser des molécules selon l'invention.

On s'intéresse d'abord à la voie de synthèse chimique :

On fabrique l'ion $\alpha_1^{2-}$ de la manière suivante

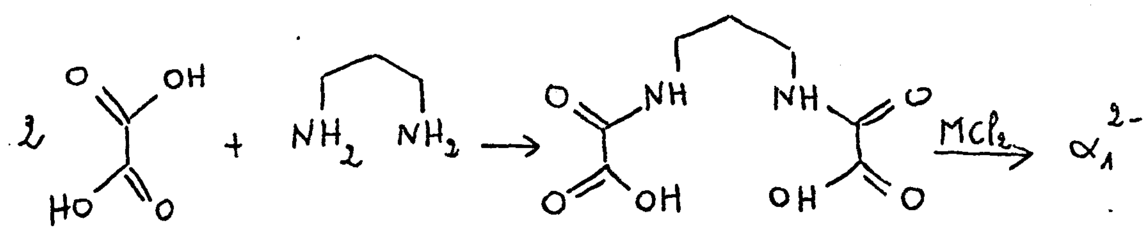


avec

$\alpha_1^{2-}$ = 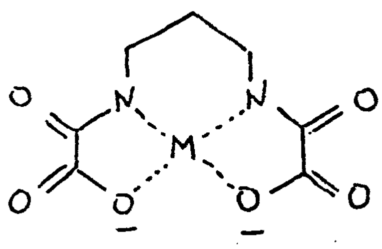

$\alpha_1^{2-}$ réagit avec tout composé de type $M'X_2$ (X étant par exemple le chlore) dans le méthanol pour donner :

$$2\,\alpha_1^{2-} + M'X_2 \longrightarrow \alpha_1 M' \alpha_1^{2-} + 2X^-$$

En laissant faire la réaction on forme naturellement une chaîne bimétallique de la forme :

$\alpha_1$ M' $\alpha_1$ M' $\alpha_1$...........

Or une telle molécule ne répond pas à la structure cantorienne selon l'invention.

Pour contrôler la structure cantorienne de la chaîne on met en oeuvre des bloqueurs, par exemple un tétraéthyléthylène diamine, un tétraméthyléthylène diamine, un pentaéthyldiéthylène triamine, ou un pentaméthyldiéthylène triamine.

Ainsi le tétraméthyléthylène diamine répond à la formule générale sui-

vante où $R_1 = R_2 = R_3 = R_4 = CH_3$.

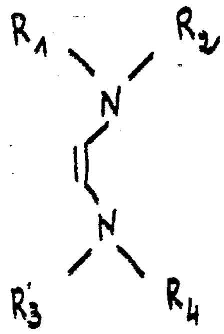

et il est apte à complexer des ions cuivre, par exemple en milieu aqueux, pour donner un composé que l'on fait réagir avec $\alpha_1^{2-}$, soit :

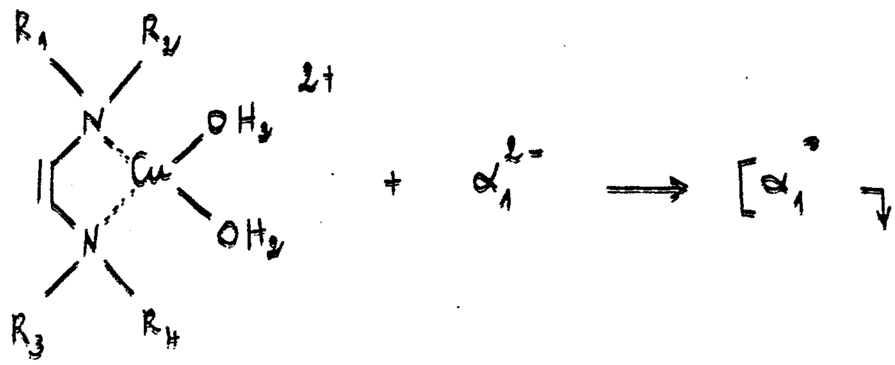

avec

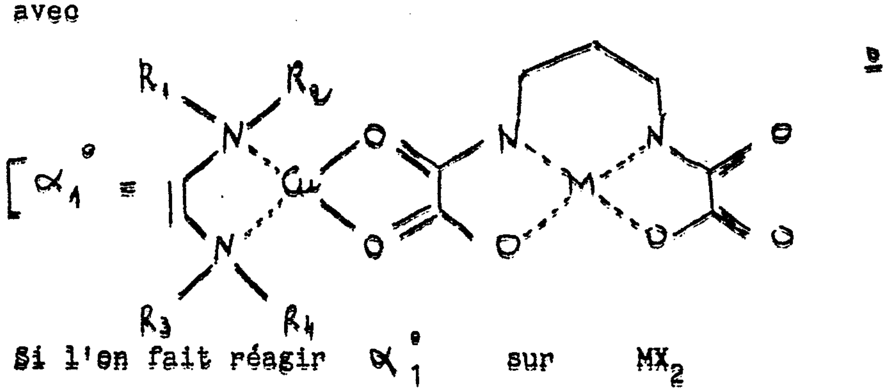

Si l'on fait réagir $\alpha_1^\circ$ sur $MX_2$ dans le méthanol on obtient :

$$2\,[\alpha_1^\circ] + MX_2 \xrightarrow{\text{Méthanol}} [\alpha_1 M \alpha_1]^{2+} + 2X^-$$

soit

$$[\alpha_1^\circ + MX_2 \rightarrow [\alpha_1 M^{2+}, 2X^- + [\alpha_1^\circ \Rightarrow [\alpha_1 M \alpha_1]^{2+} + 2X^-$$

De la même manière on peut obtenir :

$$[\alpha_1 M'\alpha_1]^{2+}$$

On réduit par voie électrochimique ce composé et on aboutit respectivement à

$$[\alpha_1 M'\alpha_1^{\circ}] \quad \text{et} \quad \alpha_1 M'\alpha_1^{2-}$$

On mélange alors ces deux corps en quantité stoéchiométrique avec $MX_2$ dans l'eau pour obtenir :

$$[\alpha_1 M'\alpha_1 M\alpha_1 M'\alpha_1 M\alpha_1 M'\alpha_1]$$

La suite de réactions peut être reprise et poursuivie pour former des séquences cantoriennes. La réduction précédente peut également se faire par voie chimique sur un corps choisi parmi le lithium, le sodium, le magnésium, le butyl-lithium, le naphtalène-sodium.... etc.

Selon la seconde méthode de synthèse précitée (unité par unité), on reprend la molécule intermédiaire obtenue plus haut $[\alpha_1 M'X_2^{\circ}$

que l'on fait réagir avec $\alpha_1^{2-}$ en présence d'eau ou de méthanol :

$$[\alpha_1 M'X_2 + (\alpha_1^{2-}, A^+) \longrightarrow [\alpha_1 M'\alpha_1^{\circ}] + AX_2 .$$

La séquence cantorienne qui caractérise l'ordre des M, M', montée ici unité par unité se superpose à un ordre binaire de sites de complexation

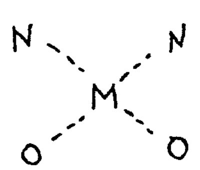

et

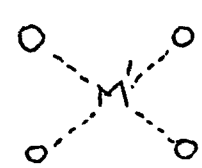

On décrit ci-dessous une autre méthode d'obtention des structures macromoléculaires selon l'invention, par voie physico-chimique.

Le principe de cette méthode consiste à mettre en oeuvre deux

feuilles métalliques, ou deux feuilles sur lesquelles on a déposé un polymère conducteur choisi par exemple parmi les polypyrroles, les polyacétylènes, les polythiophènes et leurs dérivés. On réalise une adsorption des molécules précitées $\alpha^{2-}$ sur l'une des faces de ces feuilles.

Le blocage asymétrique est ainsi assuré sur la surface. Cette opération étant faite, les deux feuilles métalliques sont calendrées et leurs faces étant disposées en regard l'une de l'autre, elles traversent un bain constitué par exemple d'un solvant tel que le méthanol et un sel de type $M'Cl_2$ . Il y a alors adhésion des feuilles par coordination de l'ion M' sur les oxygènes latéraux des molécules $\alpha^{2-}$ . On obtient $\alpha M'\alpha$ . L'adhésion aux deux faces est ensuite rompue par un passage dans un autre bain et application aux feuilles d'un potentiel négatif par rapport au bain.

On a ainsi obtenu $\alpha M'\alpha^{2-}$ .

On répète l'opération précédente avec d'une part $\alpha M'\alpha^{2-}$ et d'autre part $\alpha^{2-}$ pour obtenir $\alpha M' \alpha M \alpha^{2-}$ ; puis encore une autre fois avec cette dernière molécule et $\alpha M'\alpha^{2-}$ , de manière à créer la structure macromoléculaire recherchée c'est-à-dire

$\alpha M' \alpha M \alpha M \alpha M' \alpha^{2-}$.

L'opération peut être répétée autant de fois qu'il est nécessaire pour obtenir le matériau recherché ; cette opération peut être menée bloc par bloc, ou unité par unité.

Dans une deuxième série d'exemples, on met en oeuvre des composés soufrés susceptibles de se prêter aux synthèses cantoriennes.

Une molécule $\alpha_4$ se présente par exemple sous la forme suivante :

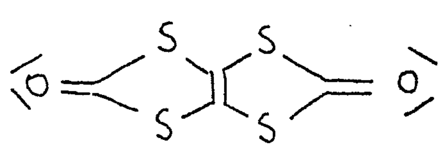

Par passage dans une base faible telle que $Na_2CO_3$ on obtient l'anion

$\alpha_4^{2-}$ = 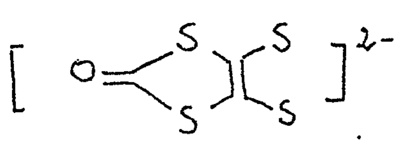

Par contre par usage de Na O Me et en portant la solution à 70°C on obtient l'anion :

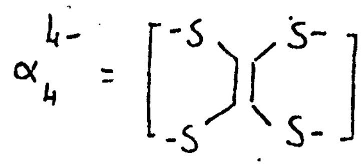

De même que précédemment on peut complexer l'anion $\alpha_4^{2-}$ à l'aide de $MX_2$ pour obtenir un composé qui peut lui même subir les ouvertures précédentes puis subir de nouvelles réactions :

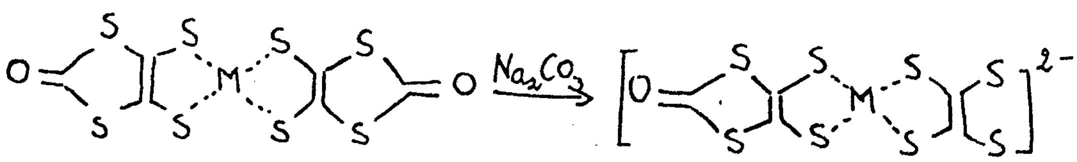


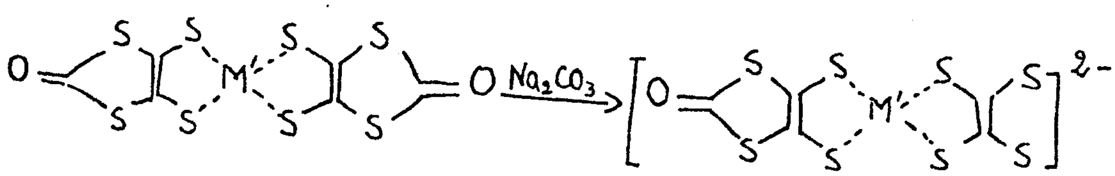


$Na_2$ $CO_3$ peut être remplacé par d'autres sels d'acide faible, par exemple de manière non limitative $Na_2$ $SO_3$ , $NaHSO_3$....

Et on coordonne deux de ces anions sur M d'une part et sur M' d'autre part avec $M'Cl_2$ ou $MCl_2$

On obtient alors :

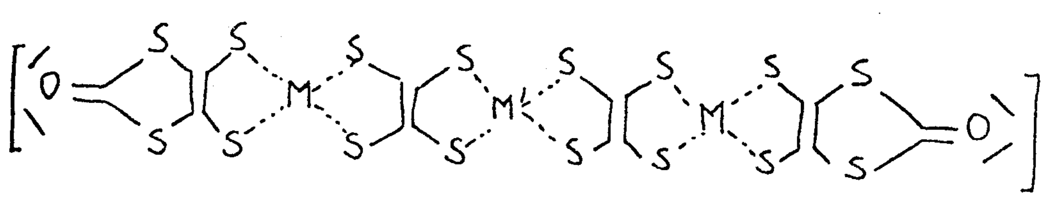

ou

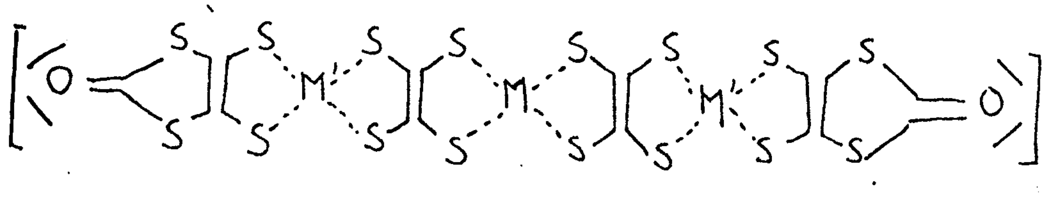

On peut alors opérer suivant deux modes de réalisation pour poursuivre la réaction :

1)

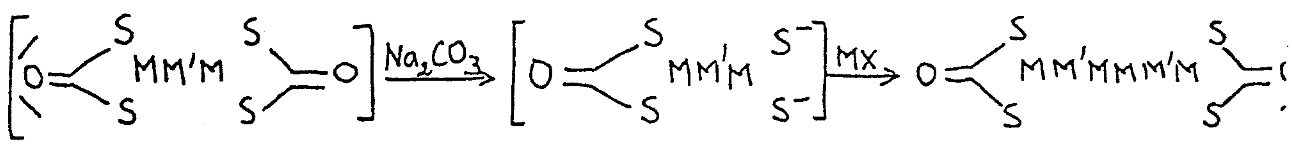


2)

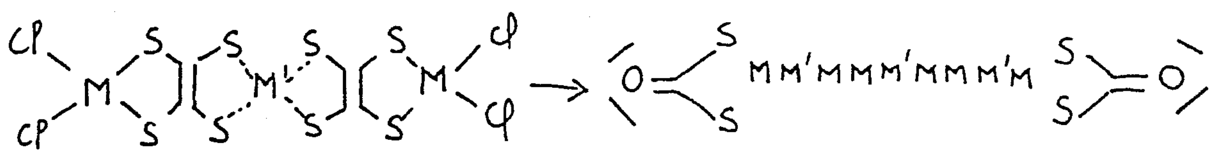

Ces premiers modes se prêtent assez mal à l'élaboration ultérieure de structures cantoriennes car il y a répartition du motif de façon symé trique, ce qui n'est en général pas le cas dans de telles structures. Par contre la seconde méthode physico-chimique précédemment décrite se prête très bien à la synthèse des molécules cantoriennes.

Ainsi on dépose sur deux surfaces métalliques un film de polymère conducteur, tel que $CH_x$ , et on y adsorbe la molécule :

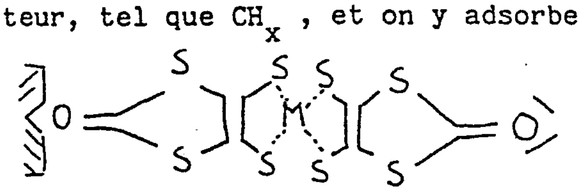

ainsi que la molécule :

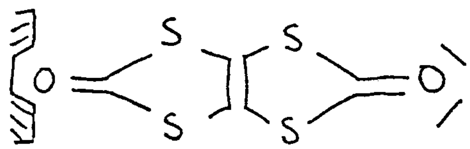

Par réduction chimique ou électrochimique on obtient sur chaque surface :

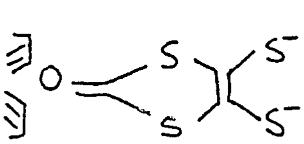 et 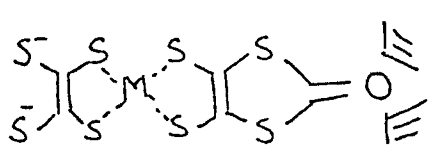

Puis dans une solution aqueuse ou alcoolique de $M'Cl_2$ on obtient à température ambiante :

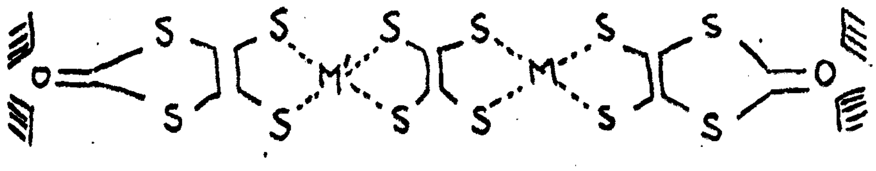

qui peut elle-même être ouverte afin que la réaction soit poursuivie.

Bien entendu l'invention n'est pas limitée aux exemples décrits. En particulier, le soufre peut dans les exemples précédents, être remplacé par le sélénium et l'on peut superposer à l'ordre cantorien métallique (M, M') un ordre cantorien (S, Se) dont la dimension peut, à volonté, être la même ou non.

Parmi les composés selon l'invention, on peut mentionner ceux qui sont du type couches de Langmuir; ils apparaissent très schématiquement dans la figure unique.

On superpose sur un support 10 qui peut être métallique, minéral ou plastique des doubles couches moléculaires $L_1$, $L_2$, $L_3$ etc...

$L_1$ est constituée d'une couche de molécules lyophiles $a_1$ et d'une couche de molécules lyophobes $a_2$.

$L_2$ est constituée d'une couche de molécules lyophiles $b_1$ et d'une couche de molécules lyophobes $b_2$.

$L_3$ est identique à $L_1$.

Dans le sens orthogonal à l'empilement, on a des molécules $\alpha$ formées par un ensemble ($a_1$, $a_2$) et des molécules $\beta$ formées par un ensemble ($b_1$, $b_2$). On imagine qu'un empilement réalisé selon la séquence f puisse aboutir à des molécules de type $\alpha\beta\alpha\ \beta\alpha$ etc... répondant aux définitions données plus haut.

Les molécules $\alpha$ peuvent être des stérarates, et $\beta$ des palmitates.

Le matériaux cantoriens décrits sont destinés à des applications électrotechniques.

On s'intéresse tout d'abord à une application en transport macroscopique de l'électricité.

Pour ce faire ces matériaux sont mis purs ou en mélange avec des polymères conducteurs, tels que le polyacétylène, le polythiophène, le polyparaphénylène, les polypyrroles...., dans des filières et l'on réalise des fils conducteurs électroniques à l'aide de ces matériaux. Ces fils présentent, en particulier à basse température, des propriétés d'hyperconductivité électrique qui autorisent

1 - la fabrication de lignes de transport de courant,

2 - la fabrication de cryoalternateurs et d'alternateurs supraconducteurs,

3 - la fabrication des filtres électriques.

On peut également mettre ces matériaux en transfert de charge avec des matériaux donneurs ou accepteurs d'électrons. Il apparaît alors sur ces matériaux des propriétés de conduction anormale susceptibles d'être utilisées dans le transport de l'électricité.

Les matériaux cantoriens peuvent être aussi appliqués comme valve ou soupape électrique par franchissement de transition métal/isolant.

Par exemple, le fait de soumettre ces matériaux à des champs magnétiques intenses conduit à des transitions de phases qui affectent la conductivité électrique ; ils peuvent donc être utilisés dans la fabrication de soupapes contrôlées (électriquement, thermiquement, magnétiquement, optiquement).

La présente invention s'applique également en électronique moléculaire pour la réalisation de propriétés spécifiques de conductivité entre fonctions moléculaires.

Dans un autre domaine l'invention s'applique à la réalisation de pigments magnétiques. La métrique est alors imposée à des matériaux sur la base de corrélation cantorienne entre spins. Il se développe alors des corrélations sur de très longues distances susceptibles de permettre la fabrication de tels pigments.

Dans un autre domaine, l'invention s'applique à la réalisation d'absorbants d'ondes électromagnétiques, par exemple sous forme de revêtements. La mise en oeuvre de la séquence sous forme de couches de Langmuir est particulièrement intéressante dans ce cas.

Ces applications n'ont été données qu'à titre d'exemples.

REVENDICATIONS

1/ Procédé de fabrication de structures macromoléculaires, caractérisé par le fait que l'on part d'une première molécule $\alpha$ , d'une seconde molécule $\beta$ , et d'une séquence f, et que l'on réalise des composés de type

$A_1 = f(\alpha, \beta)$ $B_1 = f(\beta, \beta)$

$A_2 = f(A_1, B_1)$ $B_2 = f(B_1, B_1)$

................ ..................

$A_n = f(A_{n-1}, B_{n-1})$ $B_n = f(B_{n-1}, B_{n-1})$

ou de type

$A_1 = f(\alpha, \beta)$ $B_1 = f(\alpha, \alpha)$

$A_2 = f(A_1, B_1)$ $B_2 = f(A_1, A_1)$

.............. ................

$A_n = f(A_{n-1}, B_{n-1})$ $B_n = f(A_{n-1}, B_{n-1})$

lesdits composés présentant une organisation fractale définie comme l'existence d'une séquence d'ions, d'atomes ou de molécules présentant des propriétés de self similarité.

2/ Procédé de fabrication selon la revendication 1, caractérisé par le fait que la séquence f est telle que :

$A_n = A_{n-1} B_{n-1} A_{n-1}$ et $B_n = B_{n-1} B_{n-1} B_{n-1}$

ou $A_n = A_{n-1} B_{n-1} A_{n-1}$ et $B_n = A_{n-1} A_{n-1} A_{n-1}$ .

3/ Procédé de fabrication selon la revendication 1, caractérisé par le fait que la séquence f est telle que :

$A_n = A_{n-1} B_{n-1} A_{n-1} B_{n-1} A_{n-1}$ et $B_n = B_{n-1} B_{n-1} B_{n-1} B_{n-1} B_{n-1}$

ou $A_n = A_{n-1} B_{n-1} A_{n-1} B_{n-1} A_{n-1}$ et $B_n = A_{n-1} A_{n-1} A_{n-1} A_{n-1} A_{n-1}$ .

4/ Procédé de fabrication selon la revendication 1, caractérisé par le fait que la séquence f est telle que :

$A_n = A_{n-1} B_{n-1} A_{n-1} B_{n-1}$ et $B_n = B_{n-1} B_{n-1} B_{n-1} B_{n-1}$

ou $A_n = A_{n-1} B_{n-1} A_{n-1} B_{n-1}$ et $B_n = A_{n-1} A_{n-1} A_{n-1} A_{n-1}$ .

5/ Procédé de fabrication selon la revendication 1, caractérisé par le fait que la séquence f est telle que :

$A_n = A_{n-1} A_{n-1} B_{n-1} B_{n-1}$ et $B_n = B_{n-1} B_{n-1} B_{n-1} B_{n-1}$

ou $A_n = A_{n-1} A_{n-1} B_{n-1} B_{n-1}$ et $B_n = A_{n-1} A_{n-1} A_{n-1} A_{n-1}$ .

6/ Procédé de fabrication des structures selon la revendication 1,

caractérisé par le fait qu'elles sont synthétisées par voie chimique avec utilisation d'une procédure de blocage-déblocage asymétrique des molécules pour élaborer les séquences f.

7/ Procédé de fabrication des structures selon la revendication 6, caractérisé par le fait que les molécules de départ sont choisies parmi les composés azotés et parmi les composés soufrés et séléniés.

8/ Procédé de fabrication selon l'une des revendications 6 et 7, caractérisé par le fait que les bloqueurs asymétriques sont des composés aminés choisis parmi des éthylènes diamines et des éthylènes triamines.

9/ Procédé de fabrication des structures selon la revendication 1, caractérisé par le fait qu'il consiste en une méthode de synthèse asymétrique faisant intervenir une adsorption sélective sur des surfaces qui sont ensuite mises en contact pour assurer les réactivités asymétriques.

10/ Procédé de fabrication selon la revendication 9, caractérisé par le fait que lesdites surfaces sont couvertes par des polymères conducteurs choisis parmi les polyacétylènes, polypyrroles, polythiophènes, et leurs dérivés.

11/ Procédé de fabrication selon l'une des revendications 8 et 9, caractérisé par le fait que le contrôle du processus d'adsorption-désadsorption est assuré par voie électrochimique.

12/ Procédé de fabrication selon l'une des revendications 9, 10, 11, caractérisé par le fait que la réactivité est assurée par des techniques de type chromatographique, les surfaces collées étant mises en contact et baignées dans des solutions d'échange.

13/ Procédé de fabrication selon l'une des revendications 9 à 12, caractérisé par le fait que les molécules de départ sont choisies parmi les composés de coordination soufrés et les composés de coordination azotés.

14/ Procédé de fabrication selon l'une des revendications 1 à 5, caractérisé par le fait que l'on empile sur un support des couches de Langmuir Blodgett selon ladite séquence f.

15/ Structure macromoléculaires obtenues par le procédé selon l'une des revendications précédentes.

16/ Application des structures selon la revendication 15 aux pigments magnétiques.

17/ Application des structures selon la revendication 15 aux supraconducteurs électroniques moléculaires.

18/ Application des structures selon la revendication 15 aux conducteurs électriques moléculaires.

19/ Application des structures selon la revendication 15 à l'absorption des ondes électromagnétiques.

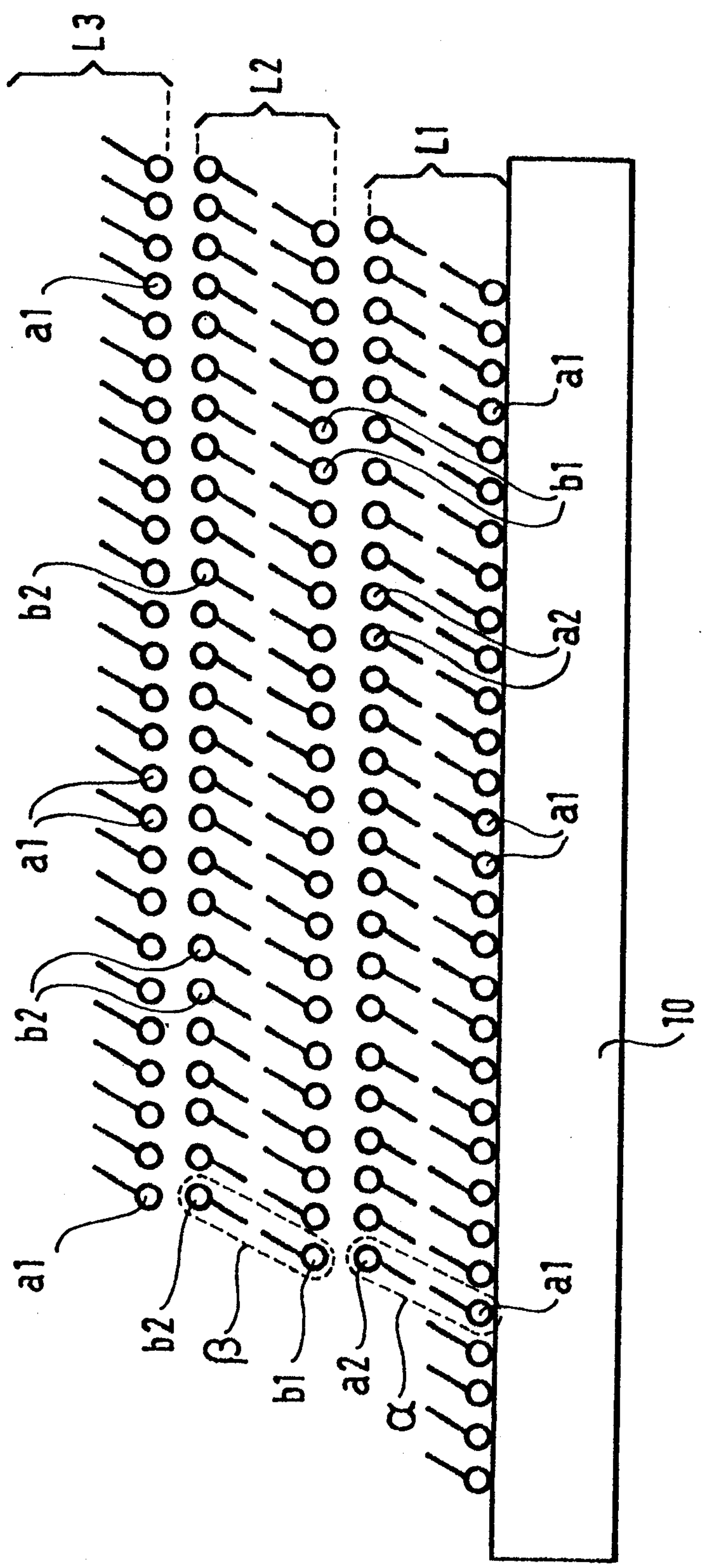
L3
L2
L1
a1
a2
b1
b2
β
α
10

Office européen des brevets

0208258

# RAPPORT DE RECHERCHE EUROPEENNE

Numero de la demande

EP 86 10 9048

## DOCUMENTS CONSIDERES COMME PERTINENTS

| Catégorie | Citation du document avec indication, en cas de besoin des parties pertinentes | Revendication concernée | CLASSEMENT DE LA DEMANDE (Int. Cl.4) |
|---|---|---|---|
| X | US-A-4 111 857 (E.M. ENGLER et al.)<br>* Revendications *<br>--- | 1-19 | C 08 G 85/00<br>C 08 G 79/00 |
| X | DIE MAKROMOLEKULARE CHEMIE, vol. 180, no. 2, février 1979, pages 345-350; G. KOSSMEHL et al.: "Synthese und Halbleitereigenschaften von hemiporphyrazinartigen Polymeren mit Tetrathiafulvalen-Einheiten"<br>* Pages 345-350 *<br>--- | 1-19 | |
| X | FR-A-1 458 963 (VARIAN ASSOCIATES)<br>* Résumé *<br>----- | 1-19 | |
| | | | DOMAINES TECHNIQUES RECHERCHES (Int. Cl.4) |
| | | | C 08 G |

Le présent rapport de recherche a été etabli pour toutes les revendications

| Lieu de la recherche | Date d'achèvement de la recherche | Examinateur |
|---|---|---|
| LA HAYE | 06-10-1986 | DERAEDT G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82